(19) Europäisches Patentamt
European Patent Office
Office européen des brevets

(11) EP 4 067 450 A1

(12) EUROPEAN PATENT APPLICATION

(43) Date of publication:
**05.10.2022 Bulletin 2022/40**

(21) Application number: **22165596.2**

(22) Date of filing: **30.03.2022**

(51) International Patent Classification (IPC):
***C09J 7/10*** *(2018.01)* ***B32B 7/12*** *(2006.01)*
***C08K 3/08*** *(2006.01)* ***H01L 21/683*** *(2006.01)*

(52) Cooperative Patent Classification (CPC):
**C09J 7/10; B32B 7/12; B32B 27/08; H01L 21/6836;**
B32B 2457/14; C08K 3/08; C08K 2201/001;
C09J 2203/326; C09J 2301/312; C09J 2301/408;
C09J 2433/00; C09J 2463/00

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.03.2021 JP 2021060074**

(71) Applicant: **Nitto Denko Corporation**
**Osaka 567-8680 (JP)**

(72) Inventors:
- **KOJIMA, Rena**
  **Osaka, 567-8680 (JP)**
- **ICHIKAWA, Tomoaki**
  **Osaka, 567-8680 (JP)**

(74) Representative: **Stolmár & Partner**
**Patentanwälte PartG mbB**
**Blumenstraße 17**
**80331 München (DE)**

(54) **THERMOSETTING SHEET AND DICING DIE BONDING FILM**

(57) A thermosetting sheet according to the present invention includes a thermosetting resin and a thermoplastic resin, in which a thickness change rate when a temperature is changed from 25 °C to 200 °C is 0% or more and 10% or less.



Processed by Luminess, 75001 PARIS (FR)

**Description**

FIELD OF THE INVENTION

The present invention relates to a thermosetting sheet and a dicing die bonding film.

BACKGROUND OF THE INVENTION

A thermosetting sheet which is adhered to an adherend when in use is conventionally known.

The thermosetting sheet is used for bonding (adhering) a semiconductor device to a substrate having a semiconductor device mounting area (i.e., for die bonding) (for example, JP 2019-021813 A). That is, the thermosetting sheet is used in, for example, producing a semiconductor apparatus. As such a thermosetting sheet, JP 2019-021813 A discloses a thermosetting sheet including conductive particles and a thermosetting resin.

In the method for producing the semiconductor apparatus as described above, for example, a semiconductor wafer and the thermosetting sheet attached to one side (i.e., a surface opposite to a circuit forming surface) of the semiconductor wafer are diced to thereby obtain a plurality of thermosetting sheets each having one side to which a semiconductor device is attached. The thermosetting sheet having the one side to which a semiconductor device is attached has the other side temporarily bonded to the area of the substrate on which the semiconductor device is mounted at a specific temperature (for example 70 °C), followed by being subjected to heat curing at a higher temperature (for example 200 °C) to be thereby bonded to the substrate (i.e., the bonding therebetween is finalized). That is, the semiconductor device is bonded to the substrate with the thermosetting sheet interposed therebetween.

SUMMARY OF THE INVENTION

Technical Problem

Meanwhile, after the bonding between the other side of the thermosetting sheet and the substrate has been finalized (for example, after bonding has been finalized at 200 °C), the thermosetting sheet on the other side is sometimes separated partially from the substrate that is an adherend. Such separation is not desirable in terms of bonding reliability of the thermosetting sheet to the adherend. Further, the occurrence of the separation in the semiconductor apparatus is not preferable as it results in insufficient electric conduction and thermal conduction via the conductive particles. However, it is hard to say that sufficient study has been made for suppression of separation of the thermosetting sheet from the substrate that is an adherend.

The problem of the separation of the thermosetting sheet as aforementioned may be also caused in the case where the adherend is any member or part other than the substrate having the semiconductor device mounting area.

Therefore, it is an object of the present invention to provide a thermosetting sheet capable of relatively suppressing the separation of a member or part from an adherend after being heat-cured, and a dicing die bonding film including the thermosetting sheet.

Solution to Problem

A thermosetting sheet according to the present invention is a thermosetting sheet including a thermosetting resin and a thermoplastic resin, in which a thickness change rate when a temperature is changed from 25 °C to 200 °C is 0% or more and 10% or less.

It is preferable that the thermosetting sheet include 60 mass parts or more and 500 mass parts or less of the thermoplastic resin based on 100 mass parts of the thermosetting resin.

It is preferable that the thermosetting sheet further include conductive particles.

It is preferable that the thermosetting sheet further include a volatile component.

It is preferable that the thermosetting sheet include 10 mass parts or more and 300 mass parts or less of the volatile component based on 100 mass parts of the thermosetting resin.

A dicing die bond film according to the present invention includes: a dicing tape that includes a base layer and an adhesive layer laminated on the base layer; and a thermosetting sheet that is laminated on the adhesive layer of the dicing tape, in which the thermosetting sheet is any one of the aforementioned thermosetting sheets.

BRIEF DESCRIPTION OF DRAWINGS

Fig. 1 is a cross-sectional view showing a configuration of a dicing die bonding film according to one embodiment of the present invention.

Fig. 2 shows a cross-sectional view showing a configuration of a semiconductor apparatus according to one embodiment of the present invention.

Fig. 3A is a graph showing the transition of a thickness change rate Rc obtained when a thermosetting sheet according to each of Examples 1 and 2 and Comparative Example 1 is subjected to a thermo-mechanical analysis.

Fig. 3B is a graph showing the transition of a thickness change rate Rc obtained when a thermosetting sheet according to each of Examples 3-5 and Comparative Example 2 is subjected to a thermo-mechanical analysis.

Fig. 4A is a SAT image of a thermosetting sheet according to Example 5 captured before the thermosetting sheet is cured.

Fig. 4B is a SAT image of a thermosetting sheet according to Example 5 captured after the thermosetting sheet is cured.

Fig. 4C is a SAT image of a thermosetting sheet according to Comparative Example 2 captured before the thermosetting sheet is cured.

Fig. 4D is a SAT image of a thermosetting sheet according to Comparative Example 2 captured after the thermosetting sheet is cured.

## DETAILED DESCRIPTION OF THE PREFERRED EMBODIMENT

Hereinafter, a description will be given on one embodiment of the present invention.

### [Thermosetting sheet]

A thermosetting sheet according to this embodiment includes a thermosetting resin and a thermoplastic resin. The thickness change rate of the thermosetting sheet according to this embodiment when the temperature is changed from 25 °C to 200 °C is 0% or more and 10% or less. The thickness change rate when the temperature is changed from 25 °C to 200 °C may be hereinafter denoted by a reference number Rc.

The thermosetting sheet that includes thermosetting resin and the thermoplastic resin and has a thickness change rate when the temperature is changed from 25 °C to 200 °C being 0% or more and 10% or less as described above can relatively suppress the shrinkage of the thermosetting sheet when the thermosetting sheet is heat-cured and the bonding to the adherend is finalized. Since an internal stress (i.e., cure shrinkage stress and heat shrinkage stress) generated in the thermosetting sheet during heat-curing can be relatively low by relatively suppressing the shrinkage of the thermosetting sheet, it is possible to suppress the separation of the thermosetting sheet from the adherend due to the internal stress. Further, the thermosetting sheet including the thermoplastic resin can have a relatively low elasticity even after being heat-cured. Thus, it is possible to secure the adhesiveness between the thermosetting sheet and the adherend even after being heat-cured.

The thickness change ratio Rc when the temperature is changed from 25 °C to 200 °C is preferably 1% or more, more preferably 3% or more. Note that the upper limit of the thickness change ratio Rc when the temperature is changed from 25 °C to 200 °C is 10% as described above.

The thickness change ratio Rc when the temperature is changed from 25 °C to 200 °C can be calculated in the following manner. Specifically, a thickness T1 of the thermosetting sheet at 25 °C is measured and a thickness T2 of the thermosetting sheet immediately after the temperature is raised to 200 °C is measured when the temperature is changed from 25 °C to 200 °C in a thermomechanical analysis (TMA), followed by calculating the thickness change ratio Rc by the equation below using the measured values T1 and T2.

$$Rc = (T2 - T1) / T1 \times 100$$

In the case where the thermosetting sheet immediately after the temperature is raised from 25 °C to 200 °C is expanded, Rc is a positive value, and in the case where the thermosetting sheet immediately after the temperature is raised from 25 °C to 200 °C is shrunk, Rc is a negative value. In the case where the thermosetting sheet is neither expanded nor shrunk, Rc is 0.

The thermomechanical analysis can be performed in the following conditions.

Conditions of thermomechanical analysis

- Thermomechanical analysis apparatus: model Q400 manufactured by TA Instruments Japan Inc.
- Probe: macro expansion probe
- Measurement mode: compression and expansion
- Temperature raising conditions: the temperature is raised from 25 °C to 200 °C in 60 min, held at 200 °C for 1 hour, and then lowered to 25 °C in 30 min.
- Measurement atmosphere: nitrogen ($N_2$)
- Load: 0.012 N (constant load)
- Test piece: A first thermosetting sheet laminate in which a plurality of thermosetting sheets are laminated is pressed under the conditions at a temperature of 70 °C and a pressure of 6 kN for 60 seconds to obtain a second thermosetting sheet laminate having a thickness of 3 mm, followed by punching the second thermosetting sheet using the punch having a diameter of 4 mm, to obtain a test piece having a thickness of 3 mm and a diameter of 4 mm.

The measurement by the thermomechanical analysis apparatus is performed by placing the test piece having both sides, on which aluminum plates (having a circular shape in a top view, a thickness of 0.1 mm, and a plane dimension with a dimeter of 5 mm) are respectively disposed, on a stage of the thermomechanical analysis apparatus to allow the aluminum plate on one side to contact the stage, followed by applying a load by the probe from the aluminum plate on the other side (i.e., the aluminum plate on the upper side). Rc can be obtained by arithmetically averaging the values obtained for two test pieces.

The thermosetting sheet according to this embodiment includes preferably 60 mass parts or more and 500 mass parts or less of the thermoplastic resin based on 100 mass parts of the thermosetting resin. Since the content of the thermoplastic resin falls within the above range, the separation of the thermosetting sheet from the adherend can be further suppressed.

The thermosetting sheet according to this embodiment includes more preferably 90 mass parts or more based on 100 mass parts of the thermosetting resin. Also, the thermosetting sheet according to this embodiment includes more preferably 400 mass parts or less, still more preferably 300 mass parts or less based on 100 mass parts of the thermosetting resin.

Examples of the thermosetting resin include an epoxy resin, a phenol resin, an amino resin, an unsaturated polyester resin, a polyurethane resin, a silicone resin, and a thermosetting polyimide resin. Among these, an epoxy resin is preferably used.

Examples of the epoxy resin include the epoxy resins of bisphenol A type, bisphenol F type, bisphenol S type, brominated bisphenol A type, hydrogenated bisphenol A type, bisphenol AF type, biphenyl type, naphthalene type, fluorene type, phenol novolak type, cresol novolak type, ortho-cresol novolak type, trishydroxyphenylmethane type, tetraphenylolethane type, hydantoin type, trisglycidyl isocyanurate type, and glycidyl amine type. Among these, at least one of a bisphenol A type epoxy resin and a cresol novolak type epoxy resin is preferably used, and a bisphenol A type epoxy resin and a cresol novolak type epoxy resin are more preferably used in combination. Examples of the bisphenol A type epoxy resin include an aliphatic modified bisphenol A type epoxy resin.

Examples of the phenol resin as a curing agent for the epoxy resin include a novolak type phenol resin, a resol type phenol resin, a biphenyl type phenol resin, and a polyoxystyrene such as polyparaoxystyrene. Among the above phenol resins, a biphenyl type phenol resin is preferably used.

A thermoplastic resin having a thermosetting functional group can also be used as a thermosetting resin. Examples of the thermoplastic resin having a thermosetting functional group include a thermosetting functional group-containing acrylic resin. Examples of the acrylic resin in the thermosetting functional group-containing acrylic resin include an acrylic resin including a monomer unit derived from a (meth)acrylate ester. For the thermoplastic resin having a thermosetting functional group, a curing agent is selected depending on the kind of the thermosetting functional group.

Examples of the thermoplastic resin includes natural rubber, a butyl rubber, an isoprene rubber, a chloroprene rubber, an ethylene-vinyl acetate copolymer, an ethylene-acrylate copolymer, an ethylene-acrylate ester copolymer, a polybutadiene resin, a polycarbonate resin, a thermoplastic polyimide resin, a polyamide resin such as polyamide 6 or polyamide 6,6, a phenoxy resin, an acrylic resin, a saturated polyester resin such as PET or PBT, a polyamide-imide resin, and a fluororesin. These kinds of thermoplastic resins may be individually used, or two or more kinds of them may be used in combination. As the thermoplastic resin, an acrylic resin is preferable in terms of its small amount of ionic impurities and high thermal resistance allowing the thermosetting sheet to easily secure connection reliability.

The acrylic resin is preferably a polymer that includes a monomer unit derived from a (meth)acrylate ester as the largest monomer unit by mass ratio. Examples of the (meth)acrylate ester include (meth)acrylate alkyl ester, (meth)acrylate cycloalkyl ester, and (meth)acrylate aryl ester. The acrylic resin may include a monomer unit derived from other component copolymerizable with the (meth)acrylate ester. Examples of the other component include a carboxyl group-containing monomer, an acid anhydride monomer, a hydroxyl group-containing monomer, a glycidyl group-containing monomer, a sulfonic acid group-containing monomer, a phosphate group-containing monomer, a functional group-containing monomer such as acrylic amid or acrylonitrile, and various multifunctional monomers. The acrylic resin is

preferably a carboxyl group-containing acrylic polymer.

It is not exactly clear why the thermosetting sheet according to this embodiment as aforementioned, which includes the thermosetting resin and the thermoplastic resin, and has a thickness change rate when the temperature is changed from 25 °C to 200 °C being 0% or more and 10% or less, can relatively suppress partial separation of the thermosetting sheet from the adherend. Nevertheless, the present inventors presume the reasons as below.

The thermosetting sheet has thermosetting properties and includes, in general, a thermosetting resin. Since the thermosetting resin is generally heat-cured, while being crosslinked at a relatively high crosslinking density, a volume shrinkage occurs in the thermosetting sheet including the thermosetting resin when the thermosetting sheet is heat-cured to be bonded to the adherend. Thus, it is considered that the thermosetting sheet is separated partially from the adherend by the volume shrinkage. In contrast, since the thermosetting sheet according to this embodiment includes a thermoplastic resin in addition to the thermosetting resin, it is considered that crosslinking of the thermoplastic resin at a relatively high crosslinking density can be suppressed. That is, it is considered that a relatively loose crosslinking structure can be formed in the thermosetting sheet. Further, since the thermosetting sheet according to this embodiment is adjusted so that the thickness change rate Rc (i.e., change rate of the thickness T2 of the thermosetting sheet immediately after the temperature is raised to 200 °C to the thickness T1 of the thermosetting sheet at the temperature of 25 °C) when the temperature is changed from 25 °C to 200 °C does not become a negative value and falls within the above numerical range (i.e., 0% or more and 10% or less), it is considered that the excessive increase in value of the thickness change rate Rc (i.e., the excessive expansion of the thermosetting sheet) can be suppressed, and hence the partial separation of the thermosetting sheet from the adherend, can be suppressed. The present inventors thus presume that the partial separation of the thermosetting sheet according to this embodiment from the adherend can be suppressed.

The thermosetting sheet according to this embodiment can be obtained by appropriate adjustment of the thickness change rate Rc by appropriate adjustment of the content of the thermosetting resin and the content of the thermoplastic resin in the thermosetting sheet. More specifically, the thickness change rate Rc can be appropriately adjusted by increasing the content of the thermoplastic resin in the thermosetting sheet, that is, by relatively decreasing the content of the thermosetting resin in the thermosetting sheet. Note that excessively increased content of the thermoplastic resin may hinder the progress of the heat-curing of the thermosetting sheet, and excessively increased thickness change rate Rc (i.e., the the excessive expansion of the thermosetting sheet) may deteriorate the bonding reliability of the thermosetting sheet to the adherend. Thus, the content of the thermoplastic resin needs be appropriately adjusted so that the thickness change rate Rc falls within the above numerical range (i.e., 0% or more and 10% or less). Further, as described later, in the case where the thermosetting sheet according to this embodiment includes the conductive particles, the higher the content of the conductive particles, the lower the content of organic components such as the thermosetting resin and the thermoplastic resin. This results in low degree of volume shrinkage of the thermosetting sheet caused by the thermosetting resin. Thus, when the thermosetting sheet according to this embodiment includes the conductive particles in addition to the thermosetting resin and the thermoplastic resin, the contents of these components can be appropriately adjusted to thereby appropriately adjust the thickness change rate Rc to fall within the above numerical range (i.e., 0% or more and 10% or less).

When the thermosetting sheet according to this embodiment is bonded to the substrate having the semiconductor device mounting area when in use (i.e., when it is used in production of the semiconductor apparatus), it is more preferable that the thermosetting sheet further include the conductive particles in addition to the thermosetting resin and the thermoplastic resin. Further, when the thermosetting sheet according to this embodiment is used in production of the semiconductor apparatus, it is preferable that the thermosetting sheet further include a volatile component in addition to the conductive particles. Note that the conductive particles herein mean particles having an electric conductivity measured according to JIS K 0130 (2008) of 100 μS/cm or less.

The thermosetting sheet according to this embodiment further including the conductive particles makes it possible to allow the thermosetting sheet to exhibit the electric conductivity and the thermal conductivity via the conductive particles, in addition to suppress the separation of the thermosetting sheet from the adherend. Further, the thermosetting sheet according to this embodiment further including the volatile component in addition to the conductive particles can reduce the volume of the thermosetting sheet itself by allowing the volatile component to be volatilized during heat-curing of the thermosetting sheet. The more the volume of the thermosetting sheet is reduced, the closer the conductive particles become to each other in the thermosetting sheet, allowing the conductive particles to easily form a thermal conduction path in the thermosetting sheet. This allows thermal conductivity after being cured to be relatively high.

The thermosetting sheet according to this embodiment includes preferably 700 mass parts or more, more preferably 1,000 mass parts or more, still more preferably 2,000 mass parts or more, of the conductive particles based on 100 mass parts of the thermosetting resin. The thermosetting sheet according to this embodiment includes preferably 45,000 mass parts or less, more preferably 16,000 mass parts or less, still more preferably 10,000 mass parts or less, particularly preferably 8,000 mass parts or less, of the conductive particles based on 100 mass parts of the thermosetting resin. In particular, the thermosetting sheet including 16,000 mass parts or less of the conductive particles based on 100 mass parts of the thermosetting resin can further maintain its sheet shape.

The thermosetting sheet according to this embodiment preferably includes 10 mass parts or more and 300 mass parts or less of the volatile component based on 100 mass parts of the thermosetting resin. The content of the volatile component falling with the above range can allow the conductive particles to more easily form a thermal conduction path in the thermosetting sheet. This allows thermal conductivity after being cured to be much higher. The thermosetting sheet according to this embodiment preferably includes 20 mass parts or more of the volatile component based on 100 mass parts of the thermosetting resin. Further, the thermosetting sheet according to this embodiment includes more preferably 250 mass parts or less, still more preferably 200 mass parts or less, particularly preferably 100 mass parts or less of the volatile component based on 100 mass parts of the thermosetting resin.

The conductive particles preferably include silver particles. The shape of the silver particles may be, for example, a flake shape, a needle shape, a filament shape, a spherical shape, and a flat shape (including a scale-like shape), among which a spherical shape is preferably employed. Use of the silver particles having a spherical shape can increase the dispersibility of the silver particles in the thermosetting sheet.

The silver particles may be silver particles composed of the silver element and other elements (e.g., metal elements) included as inevitable impurity elements, or may be silver particles subjected to surface treatment (for example, silane coupling treatment). Examples of the surface treatment agent for the silver particles include coating agents that are aliphatic acid-based, amine-based, epoxy-based, and the like. Examples of the commercially available silver particles subjected to surface treatment with an aliphatic acid-based coating agent include AG-2-8F manufactured by DOWA Electronics Materials Co., Ltd., and examples of the commercially available silver particles subjected to surface treatment with an epoxy-based coating agent include HP02 manufactured by MITSUI MINING & SMELTING CO., LTD. The silver particles subjected to surface treatment with an aliphatic acid-based, amine-based, or epoxy-based coating agent may be hereinafter referred to as the silver particles treated with a coating agent. In the thermosetting sheet according to this embodiment, the silver particles treated with a coating agent are preferably used as the silver particles. Since the use of the silver particles treated with a coating agent as the silver particles can increase affinity for the resin component (i.e., the thermosetting resin and the thermoplastic resin) included in the thermosetting sheet, the silver particles are easily dispersed in the thermosetting sheet.

The conductive particles may include nickel particles, copper particles, aluminum particles, carbon black, carbon nanotubes, particles formed by plating the surfaces of core metal particles with a metal such as gold or silver (hereinafter referred to also as plated metal particles), particles formed by coating the surfaces of core resin particles with a metal (hereinafter referred to also as metal-coated resin particles), and the like, other than the silver particles. These kinds of conductive particles may be individually used, or two or more kinds of them may be used in combination.

As the plated metal particles, for example, particles in which nickel particles or copper particles serve as cores and the surfaces of the cores are plated with a noble metal such as gold or silver can be used. As the metal-coated resin particles, for example, particles in which resin particles serve as cores and the surfaces of the cores are coated with a metal such as nickel or gold can be used. In the case where the thermosetting sheet according to this embodiment includes conductive particles other than the silver particles, the plated metal particles are preferably used as the conductive particles, and particles in which copper particles serve as cores and the surfaces of the cores are plated with silver (silver-coated copper particles) are preferably used as the plated metal particles. Examples of the commercially available silver-coated copper particles include: particles obtained by coating product name 1200Y (copper particles) manufactured by MITSUI MINING & SMELTING CO., LTD. with 20 mass % of silver particles; particles obtained by coating product name MA-C03K (copper particles) manufactured by MITSUI MINING & SMELTING CO., LTD. with 20 mass % of silver particles; and product name AOP-TCY-2 (EN) manufactured by DOWA Electronics Materials Co., Ltd. In the case where the thermosetting sheet according to this embodiment includes conductive particles other than the silver particles, the mass % of the silver particles in 100 mass parts of the conductive particles is preferably 10 mass parts or more and 95 mass parts or less, more preferably 20 mass parts or more and 90 mass parts.

The shape of the conductive particles other than the silver particles may be, for example, a flake shape, a needle shape, a filament shape, a spherical shape, and a flat shape (including a scale-like shape), among which a spherical shape is preferably employed. Use of the particles having a spherical shape as the conductive particles other than the silver particles can increase the dispersibility of the conductive particles other than the silver particles in the thermosetting sheet. Since the spherical particles have a smaller specific surface area than flat-shaped particles, use of the spherical particles as the conductive particles other than the silver particles results in a smaller contact area between the silver particles and the conductive particles other than the silver particles, which can be deemed disadvantageous in terms of the electric conductivity and thermal conductivity. However, since the thermosetting sheet according to this embodiment includes the volatile component that volatizes while the thermosetting sheet is being heat cured, the thermosetting sheet reduces its volume (i.e., volume of the thermosetting sheet shrinks) after being cured to allow the silver particles and the conductive particles other than the silver particles to be positionally close to each other. Thus, even when the spherical particles are used as the conductive particles other than the silver particles, a sufficient contact area between the silver particles and the conductive particles other than the silver particles can still be secured, and thereby the electric conductivity and the thermal conductivity can be sufficiently secured. The particles obtained by

coating product name 1200Y manufactured by MITSUI MINING & SMELTING CO., LTD. with 20 mass % of silver particles, the particles obtained by coating product name MA-C03K manufactured by MITSUI MINING & SMELTING CO., LTD. with 20 mass % of silver particles, and product name AOP-TCY-2 (EN) manufactured by DOWA Electronics Materials Co., Ltd., which have been aforementioned, all fall under having a spherical shape.

Examples of the volatile component can include an organic compound that includes one or more hydroxy groups and has a boiling point of 250 °C or higher. The boiling point of the organic compound is preferably 350 °C or less. Examples of such an organic compound may include a terpene compound. As the volatile component, isobornyl cyclohexanol expressed by a following formula (1) is preferable among terpene compounds. Isobornyl cyclohexanol is an organic compound with a boiling point of 308 to 318 °C, and has characteristics that, when heated under a nitrogen gas flow of 200 mL/min from room temperature (23 ± 2 °C) to 600 °C at a temperature rising rate of 10 °C/min, weight reduction becomes significant when the temperature reaches 100 °C and such significant weight reduction continues as the temperature increases, and volatilization and vanishment occurs (i.e., no further weight reduction is found) at 245 °C. Isobornyl cyclohexanol has further characteristics that it has an extremely high viscosity of 1,000,000 Pa·s at 25 °C but has a relatively low viscosity of 1000 mPa·s or less at 60 °C. The weight reduction refers to a value obtained when the weight reduction ratio at a measurement starting temperature (room temperature) is 0%. Isobornyl cyclohexanol exhibits an extremely high viscosity at 25 °C as aforementioned and thus can keep the thermosetting sheet in a sheet shape at room temperature, but it exhibits a relatively low viscosity at 60 °C as described above to have tackiness. That is, the thermosetting sheet including isobornyl cyclohexanol is excellent in capability of keeping itself in a sheet shape at room temperature, and has tackiness at 60 °C and higher. When a semiconductor device bonded to one side of the thermosetting sheet is mounted on a metal lead frame or the like, it is general that the semiconductor device is temporarily bonded (fixed) to an adherend such as the metal lead frame via the thermosetting sheet at a temperature of 60 to 80 °C. In the case where the thermosetting sheet according to this embodiment includes, as the volatile component, isobornyl cyclohexanol, which causes tackiness at 60 °C and higher as aforementioned, the temporary bonding of the thermosetting sheet to an adherend such as a metal lead frame is more improved. That is, the thermosetting sheet in the state of being temporarily bonded suppresses the semiconductor device from being displaced from its mounting position, and is suppressed from rising from the adherend. Thus, the semiconductor device can be reliably bonded to the adherend by heat-curing the thermosetting sheet.

Formula 1

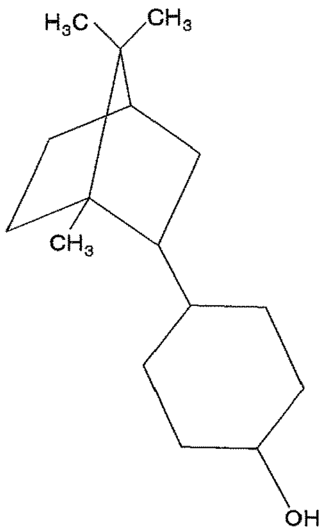

···(1)

The thermosetting sheet according to this embodiment may include a thermosetting catalyst in terms of sufficiently progressing the curing reaction of the resin component or increasing the curing reaction rate. Examples of the thermosetting catalyst include an imidazole-based compound, a triphenylphosphine-based compound, an amine-based compound, and a trihalogenborane-based compound.

In the thermosetting sheet according to this embodiment, the packing ratio $P_1$ of the conductive particles in the thermosetting sheet before being cured is preferably 30 volume % or more, more preferably 40 volume % or more, further preferably 50 volume % or more. The packing ratio $P_1$ of the particles is preferably 70 volume % or less, more preferably 60 volume % or less.

In the thermosetting sheet according to this embodiment, the packing ratio $P_2$ of the conductive particles in the thermosetting sheet after being cured is preferably 40 volume % or more, more preferably 50 volume % or more, further preferably 60 volume % or more. The packing ratio $P_2$ of the particles is preferably 80 volume % or less, more preferably 75 volume % or less. The packing ratio $P_2$ of the particles falling within the above value range can further increase heat dissipation of the cured thermosetting sheet. The packing ratio herein refers to a proportion of the conductive particles occupied per unit volume, and as will be described below, the packing ratio can be obtained by capturing an SEM image of a given area of the cross section of the thermosetting sheet made to be exposed by mechanical polishing using a field emission scanning electron microscope to thereby obtain a reflected electron image as image data and then analyze the image data.

The packing ratio $P_1$ of the particles can be obtained with the following steps:

(1) The thermosetting sheet before being cured is mechanically polished to expose its cross section, and the exposed cross section is subjected to ion polishing using an ion polisher (for example, product name: Cross Section Polisher SM-09010 manufactured by JEOL, Ltd.).
(2) An SEM image (an image obtained by a scanning electron microscope) of a given cross-sectional area of the exposed cross section that has been ion-polished is captured using a field emission scanning electron microscope (for example, product name SU8020 manufactured by Hitachi High-Tech Corporation) at an accelerating voltage of 5 kV and at a magnification of 5000 times to obtain a reflected electron image as an image data.
(3) The obtained image data is subjected to automatic binarization processing, in which the data is binarized into a metal portion and a resin portion using image analysis software (for example, ImageJ).
(4) The total area of the conductive particles portion and the entire (conductive particles portion + resin portion) area are obtained from the binarized image, and the total area of the conductive particles portion is divided by the entire area to obtain the packing ratio $P_1$ of the conductive particles in the cured thermosetting sheet.

It is preferable that the packing ratio $P_1$ of the particles be obtained by arithmetically averaging the packing ratios obtained for five cross-sectional areas in the exposed cross section that has been ion-polished. The packing ratio $P_2$ of the particles in the cured thermosetting sheet can also be obtained in the same manner as described above.

The thermosetting sheet according to this embodiment has a thickness of preferably 5 μm or more, more preferably 10 μm or more, further preferably 20 μm or more. The thermosetting sheet has a thickness of preferably 150 μm or less, more preferably 100 μm or less, further preferably 80 μm or less. The thermosetting sheet having a thickness of 150 μm or less can have more improved thermal conductivity. The thickness of the thermosetting sheet can be obtained by measuring the thickness thereof at any five positions selected at random using a dial gauge (model R-205 manufactured by PEACOCK), followed by arithmetically averaging these thickness values.

The thermosetting sheet according to this embodiment has a thermal conductivity after being cured of preferably 3 W/m·K or more. The thermal conductivity after being cured falling within the above value range can further increase the conductivity of the cured thermosetting sheet. In the thermosetting sheet according to this embodiment, the upper limit of the thermal conductivity after being cured is generally 100 W/m·K. The thermal conductivity after being cured can be calculated using the equation below for a heat-cured thermosetting sheet obtained by heat-curing the thermosetting sheet according to this embodiment using a pressure cooker apparatus under 0.5 MPa pressure at 200 °C for an hour:

$$\text{Thermal conductivity (W/m·K)} = \text{Thermal diffusivity } (m^2/s) \times \text{Specific heat (J/g·°C)} \times \text{Specific weight } (g/cm^3)$$

The thermal diffusivity ($m^2/s$) in the above equation can be measured by the TWA method (temperature wave analysis, measuring instrument: ai-Phase Mobile manufactured by ai-Phase Co., Ltd.). The specific heat (J/g· °C) in the above equation can be measured by the DSC method. In the specific heat measurement, DSC6220 manufactured by SII NanoTechnology Inc. is used at a temperature rising rate of 10 °C/min and in a temperature range of 20 to 300 °C to obtain the data, based on which the specific heat can be calculated according to the method stipulated in the JIS handbook (Testing Methods for Specific Heat Capacity of Plastics: K-7123). Further, the specific weight in the above equation can be measured by the Archimedes method.

The thermosetting sheet according to this embodiment may include one or more kinds of other components as needed. Examples of the other components include a filler dispersant, a flame retarder, a silane coupling agent, and an ion trapping agent.

[Dicing die bonding film]

Next, a description will be given on a dicing die bonding film 20 with reference to Fig. 1. Hereinafter, any description that has already been given for describing the thermosetting sheet will not be repeated.

As shown in Fig. 1, the dicing die bonding film 20 according to this embodiment includes an adhesive layer 2 laminated on a base layer 1 to form a dicing tape 10, and a thermosetting sheet 3 laminated on the adhesive layer 2 of the dicing tape 10. The dicing die bonding film 20 has a semiconductor device attached on the thermosetting sheet 3. The semiconductor device may be a bare wafer. The bare wafer attached to the dicing die bonding film 20 according to this embodiment is cut into a plurality of bare chips by blade dicing, DBG (dicing before grinding) or SDBG (stealth dicing before grinding), or the like. The thermosetting sheet 3 is also cut at the time of the cutting of the bare wafer as above. The thermosetting sheet 3 is cut into pieces each having a size corresponding to the size of each of the plurality of bare chips formed into individual pieces. The plurality of bare chips with the thermosetting sheet 3 can be thus obtained.

As aforementioned, the thermosetting sheet 3 of the dicing die bonding film 20 includes a thermosetting resin and a thermoplastic resin and has a thickness change rate when the temperature is changed from 25 °C to 200 °C is 0% or more and 10% or less.

The base layer 1 supports the adhesive layer 2, and the thermosetting sheet 3 laminated on the adhesive layer 2. The base layer 1 includes a resin. Examples of the resin include an olefin-based resin such as polyethylene (PE), polypropylene (PP), or an ethylene-propylene copolymer; a copolymer including ethylene as a monomer component, such as an ethylene-vinyl acetate copolymer (EVA), an ionomer resin, an ethylene-(meth) acrylate copolymer, or an ethylene-(meth)acrylate ester (random or alternate) copolymer; a polyester such as polyethylene terephthalate (PET), polyethylene naphthalene (PEN), or polybutylene terephthalate (PBT); an acrylic resin; polyvinyl chloride (PVC); a polyurethane; a polycarbonate; polyphenylene sulfide (PPS); an amide-based resin such as polyamide or wholly aromatic polyamide (aramid); polyether ether ketone (PEEK); a polyimide; a polyether imide; polyvinylidene chloride; an acrylonitrile butadiene styrene copolymer (ABS); a cellulose-based resin; a silicone resin; and a fluororesin. Among these, polyethylene terephthalate is preferably included in the base layer 1.

The base layer 1 may include one kind of the aforementioned resins, or may include two or more kinds of the aforementioned resins.

A material of the base layer 1 may be a crosslinked polymer or the like of any of the resins (for example, a plastic film). The plastic film may be used without being stretched, or may be subjected to uniaxial or biaxial stretching as needed for use. According to a resin sheet to which heat shrinkability is imparted by stretching or the like, a contact area between the adhesive layer 2 and the thermosetting sheet 3 can be reduced by causing the base layer 1 of the resin sheet to heat shrink after dicing, to thereby allow semiconductor chips (semiconductor devices) to be easily collected.

A surface of the base layer 1 may be subjected to a general surface treatment to increase, for example, its tight adhesiveness to an adjacent layer, or its capability of being secured to the adjacent layer. Examples of the surface treatment include a chemical or physical treatment such as chromic acid treatment, ozone exposure, flame exposure, high-pressure electric shock exposure, or ionized radiation treatment; and coating treatment using a primer.

The base layer 1 has a thickness of preferably 1 μm or more and 1000 μm or less, more preferably 10 μm or more and 500 μm or less, further preferably 20 μm or more and 300 μm or less, particularly preferably 30 μm or more and 200 μm or less. The thickness of the base layer 1 can be obtained using a dial gauge (model R-205 manufactured by PEACOCK), as in the thickness of the thermosetting sheet 3 as aforementioned.

The base layer 1 can include various additives. Examples of the various additives include a colorant, a filler, a plasticizer, an aging retardant, an antioxidant, a surfactant, and a flame retarder.

An adhesive used for forming the adhesive layer 2 is not particularly limited, and for example a general pressure-sensitive adhesive such as an acrylic adhesive or a rubber adhesive can be used. The pressure-sensitive adhesive is preferably an acrylic adhesive including an acrylic polymer as a base polymer in terms of, for example, securing clean washability of electronic components such as semiconductor wafers or glasses, which should be kept away from contamination, using ultrapure water or an organic solvent such as an alcohol.

Examples of the acrylic polymer include an acrylic polymer that includes, as a monomer component, one or more kinds of a (meth)acrylate alkyl ester and a (meth)acrylate cycloalkyl ester. Examples of the (meth)acrylate alkyl ester can include a linear or branched alkyl ester having a 1-30C, particularly 4-18C alkyl group, such as methyl ester, ethyl ester, propyl ester, isopropyl ester, butyl ester, isobutyl ester, s-butyl ester, t-butyl ester, pentyl ester, isopentyl ester, hexyl ester, heptyl ester, octyl ester, 2-ethylhexyl ester, isooctyl ester, nonyl ester, decyl ester, isodecyl ester, undecyl ester, dodecyl ester, tridecyl ester, tetradecyl ester, hexadecyl ester, octadecyl ester, or eicosyl ester. Examples of the (meth)acrylate cycloalkyl ester can include cyclopentyl ester and cyclohexyl ester. The (meth)acrylate ester means at least one of the acrylate ester or the methacrylate ester, and the term (meth) herein is used in the same way as above throughout the specification.

The acrylic polymer may include a unit corresponding to another monomer component that is copolymerizable with the (meth)acrylate alkyl ester or the (meth)acrylate cycloalkyl ester, as appropriate, for the purpose of improving

cohesive force, heat resistance, or the like. Examples of such a monomer component include: a carboxyl group-containing monomer such as acrylate, methacrylate, carboxyethyl (meth)acrylate, carboxypentyl (meth)acrylate, itaconic acid, maleic acid, fumaric acid, or crotonic acid; an acid anhydride monomer such as maleic anhydride or itaconic anhydride; a hydroxyl group-containing monomer such as 2-hydroxythyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, or (4-hydroxymethyl cyclohexyl) methyl (meth)acrylate; a sulfonic acid group-containing monomer such as styrenesulfonic acid, arylsulfonic acid, 2-(meth)acrylamide-2-methylpropanesulfonic acid, (meth)acryloyloxynaphthalenesulfonic acid, or sulfopropyl (meth)acrylate; a phosphate group-containing monomer such as 2-hydroxyethyl acryloyl phosphate; acrylamide; and acrylonitrile. One or more kinds of these copolymerizable monomer components can be used. The amount of these copolymerizable monomers in use is preferably 40 mass % or less of the total monomer components.

The acrylic polymer can further include a multifunctional monomer or the like as a copolymerizing monomer component as needed for crosslinking. Examples of such a multifunctional monomer include hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, tripmethylolpropane tri(meth)acrylate, pentaerythritol tri(meth)acrylate, dipentaerythritol hexa(meth)acrylate, epoxy (meth)acrylate, polyester (meth)acrylate, and urethane (meth)acrylate. One or more kinds of these multifunctional monomers can be used. The amount of these multifunctional monomers in use is preferably 30 mass % or less of the total monomer components in terms of, for example, their adhesion characteristics.

The acrylic polymer can be obtained by polymerizing a single monomer or two or more kinds of monomer mixtures. The polymerization may be performed by any of solution polymerization, emulsion polymerization, bulk polymerization, suspension polymerization, and the like. The acrylic polymer preferably has a small content of low-molecular weight substances in terms of, for example, preventing a clean adherend from contamination. In this regard, the number average molecular weight of the acrylic polymer is preferably 300,000 or more, more preferably about 400,000 to 3,000,000.

An external crosslinking agent can be appropriately added to the adhesive, in order to increase the number average molecular weight of the acrylic polymer or the like, which is the base polymer of the adhesive. Specific examples of the external crosslinking method include a method which includes adding a crosslinking agent such as a polyisocyanate compound, an epoxy compound, an aziridine compound, or a melamine-based crosslinking agent to the adhesive to cause a reaction. In the case where the external crosslinking agent is used, the amount of the external crosslinking agent in use is determined as appropriate, in consideration of the balance with the amount of the base polymer to be crosslinked and its intended use as the adhesive. Generally, the amount of the external crosslinking agent mixed with the base polymer is preferably about 5 mass parts or less, more preferably 0.1 to 5 mass parts based on 100 mass parts of the base polymer.

In addition to the aforementioned components, the adhesive may include additives such as any known tackifier and aging retardant as appropriate.

The adhesive layer 2 can be formed of a radiation-curable adhesive. The radiation-curable adhesive can easily reduce its pressure-sensitive adhesiveness by being irradiated with radiation such as ultraviolet rays to increase the degree of crosslinking. That is, the adhesive layer 2 formed of the radiation-curable adhesive allows the thermosetting sheet 3 to be in sufficient contact with the adhesive layer 2 without being subjected to radiation irradiation before dicing, and reduces its pressure-sensitive adhesiveness by being subjected to radiation irradiation after dicing so that semiconductor chips (semiconductor devices) can be easily picked up or collected.

The radiation-curable adhesive is not particularly limited, and can be any adhesive as long as it has a radiation-curable functional group of a carbon-carbon double bond or the like, and exhibits pressure-sensitive adhesiveness. Examples of the radiation-curable adhesive include an additive-type radiation-curable adhesive in which a radiation-curable monomer component or oligomer component is mixed with a general pressure-sensitive adhesive such as an acrylic adhesive or a rubber adhesive.

Examples of the radiation-curable monomer component include urethane (meth)acrylate, trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, and 1,4-butanediol di(meth)acrylate. Examples of the radiation-curable oligomer component include a urethane-based oligomer, a polyether-based oligomer, a polyester-based oligomer, a polycarbonate-based oligomer, a polybutadiene-based oligomer, and various other oligomers, and any of these oligomers having a molecular weight of about 100 to 30,000 is preferable. The mixing amount of the radiation-curable monomer component or the radiation-curable oligomer component is preferably such an amount as to allow the adhesive layer 2 to appropriately reduce its pressure-sensitive adhesiveness after radiation irradiation. Generally, the mixing amount of the radiation-curable monomer component or the radiation-curable oligomer component is, for example, preferably 5 to 500 mass parts, more preferably 40 to 150 mass parts, based on the 100 mass parts of the base polymer such as an acrylic polymer constituting the adhesive.

In addition to the additive-type radiation-curable adhesives mentioned above, the radiation-curable adhesive

can be an intrinsic-type radiation-curable adhesive in which a polymer having a carbon-carbon double bond in a side chain or the main chain of the polymer or at a terminal of the main chain is used as the base polymer. The intrinsic-type radiation-curable adhesive does not need to include an oligomer component or the like, which is a low-molecular component, or includes a relatively small content of the oligomer component or the like. Thus, the use of the intrinsic-type radiation-curable adhesive suppresses the oligomer component or the like from migrating within the adhesive layer 2 over time. As a result, the adhesive layer 2 can have a relatively stable layer structure.

The base polymer having the carbon-carbon double bond is not particularly limited as long as it has a carbon-carbon double bond and has pressure-sensitive adhesiveness. Such a base polymer preferably has an acrylic polymer as the basic skeleton. Examples of the basic skeleton of the acrylic polymer include the aforementioned acrylic polymers.

A method for introducing the carbon-carbon double bond into the acrylic polymer is not particularly limited and various methods can be employed, but when adopting a method in which the carbon-carbon double bond is introduced in a polymer side chain, molecular design can be easily made. Examples of the method include a method in which a monomer having a functional group is in advance caused to copolymerize with the acrylic polymer, followed by subjecting a compound having the carbon-carbon double bond and a functional group that can react with the functional group of the monomer to a condensation reaction or an addition reaction in the state where the carbon-carbon double bond is kept radiation-curable.

Examples of the combination of the functional groups include: a carboxylic acid group and an epoxy group, a carboxylic acid group and an aziridinyl group, and a hydroxyl group and an isocyanate group. Among these combinations of the functional groups, a combination of a hydroxyl group and an isocyanate group is preferable in terms of easy reaction tracking. In these combinations of the functional groups, any of the functional groups can be present on any side of the acrylic polymer and the compound having the carbon-carbon double bond, as long as the combination of the functional groups generates an acrylic polymer having the carbon-carbon double bond. In the case of the aforementioned preferable combination, however, it is preferable that the acrylic polymer have a hydroxyl group and the compound having the carbon-carbon double bond have an isocyanate group. In this case, examples of the isocyanate compound having the carbon-carbon double bond include methacryloyl isocyanate, 2-methacryloyloxyethyl isocyanate, and m-isopropenyl-$\alpha$,$\alpha$-dimethylbenzyl isocyanate. Examples of the acrylic polymer include a polymer formed by copolymerizing an ether-based compound or the like such as the aforementioned hydroxyl group-containing monomer, 2-hydroxyethyl vinyl ether, 4-hydroxybutyl vinyl ether, or diethylene glycol monovinyl ether.

In the intrinsic-type radiation-curable adhesive, the base polymer having the carbon-carbon double bond (in particular an acrylic polymer) may be individually used, but the radiation-curable monomer component or the radiation-curable oligomer component can be added in such an amount as not to impair the characteristics of the adhesive. The radiation-curable oligomer component or the like is included generally in the range of 30 parts or less by mass, preferably in the range of 1 to 10 mass parts, based on 100 mass parts of the base polymer.

The radiation-curable adhesive includes a photopolymerization initiator in the case of being cured by, for example, ultraviolet rays. Examples of the photopolymerization initiator include an $\alpha$-ketol-based compound such as 4-(2-hydroxyethoxy)phenyl(2-hydroxy-2-propyl) ketone, $\alpha$-hydroxy-a,a'-dimethylacetophenone, 2-methyl-hydroxypropiophenone, or 1-hydroxycyclohexyl phenyl ketone; an acetophenone-based compound such as methoxyacetophenone, 2,2-dimethoxy-2-phenylacetophenone, 2,2-diethoxyacetophenone, or 2-methyl-1-[4-(methylthio)-phenyl]-2-morpholinopropane-1; an benzoin ether-based compound such as benzoin ethyl ether, benzoin isopropyl ether, or anisoin methyl ether; a ketal-based compound such as benzil dimethylketal; an aromatic sulfonyl chloride-based compound such as 2-naphthalene sulfonyl chloride; a photoactive oxime-based compound such as 1-phenone-1,1-propanedione-2-(o-ethoxycarbonyl)oxime; a benzophenone-based compound such as benzophenone, benzoyl benzoic acid, or 3,3'-dimethyl-4-metoxybenzophenone; a thioxanthone-based compound such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, or 2,4-diisopropylthioxanthone; camphorquinone; halogenated ketone; acylphosphine oxide; and acylphosphonate. The mixing amount of the photopolymerization initiator is, for example, 0.05 to 20 mass parts based on 100 mass parts of an acrylic polymer as the base polymer constituting the adhesive.

Examples of the radiation-curable adhesive include a rubber or acrylic adhesive disclosed in JP S60-196956 A, which includes: a photopolymerizable compound such as an addition polymerizable compound having two or more unsaturated bonds or alkoxysilane having an epoxy group; and a photopolymerization initiator such as a carbonyl compound, an organic sulfur compound, a peroxide, amine, or an onium saltbased compound.

In the case where curing inhibition by oxygen occurs at the time of radiation irradiation, it is desirable to keep the surface of the radiation-curable adhesive layer 2 away from oxygen (air) using some method. For example, the method can be performed by covering the surface of the adhesive layer 2 with a separator, or by irradiating the surface of the adhesive layer 2 with radiation such as ultraviolet rays in a nitrogen gas atmosphere.

The thickness of the adhesive layer 2 is not particularly limited, but is preferably 1 to 50 $\mu$m, more preferably 2 to 30 $\mu$m, further preferably 5 to 25 $\mu$m, in terms of both preventing chipping of a chip cutting surface and achieving the capability of enabling the thermosetting sheet 3 to be secured to the adhesive layer 2 and kept in the secured state.

[Semiconductor apparatus]

The semiconductor apparatus according to this embodiment includes a substrate having a semiconductor device mounting area, and a semiconductor device mounted on the semiconductor device mounting area, in which the semiconductor device is mounted on the semiconductor device mounting area of the substrate via the thermosetting sheet, the thermosetting sheet is cured. In the semiconductor apparatus according to this embodiment, the thermosetting sheet is subjected to heat curing so that the semiconductor device is mounted on the semiconductor device mounting area of the substrate.

In the semiconductor apparatus according to this embodiment, the joining ratio (i.e., the bonding ratio) JR1 of the thermosetting sheet to the substrate before the thermosetting sheet is heat cured (hereinafter, also referred to as the joining ratio before heat-curing JR1) is preferably 85% or more, more preferably 90% or more. In the semiconductor apparatus according to this embodiment, the joining ratio JR2 of the thermosetting sheet to the substrate after the thermosetting sheet is heat cured (hereinafter, also referred to as the joining ratio after heat-curing JR2) is preferably 80% or more, more preferably 90% or more. In the semiconductor apparatus according to this embodiment, the ratio of the joining ratio after heat-curing JR2 to the joining ratio before heat-curing JR1 is preferably 80% or more, more preferably 90% or more, still more preferably 95% or more. In the semiconductor apparatus according to this embodiment, it is preferable that the joining ratio before heat-curing JR1 be 85% or more, the joining ratio after heat-curing JR2 be 80% or more, and the ratio of the joining ratio after heat-curing JR2 to the joining ratio before heat-curing JR1 be 80% or more, it is more preferable that the joining ratio before heat-curing JR1 be 90% or more, the joining ratio after heat-curing JR2 be 90% or more, and the ratio of the joining ratio after heat-curing JR2 to the joining ratio before heat-curing JR1 be 90% or more, and it is still more preferable that the joining ratio before heat-curing JR1 be 95% or more, the joining ratio after heat-curing JR2 be 90% or more, and the ratio of the joining ratio after heat-curing JR2 to the joining ratio before heat-curing JR1 be 95% or more.

The joining ratio of the thermosetting sheet to the substrate herein means a ratio of an area of the thermosetting sheet actually attached to the semiconductor device mounting area to the total area of the thermosetting sheet to be attached to the semiconductor device mounting area.

Examples of the semiconductor apparatus according to this embodiment include an apparatus configured as shown in Fig. 2. As shown in Fig. 2, a semiconductor apparatus 30 includes: a lead frame substrate 31 that includes a die pad 31a having a substantially rectangular shape as viewed from top and a pair of leads 31b respectively extending from both ends of the die pad 31a; a semiconductor device 32 mounted to the die pad 31a of the lead frame substrate 31 while being laminated on a thermosetting sheet 3; a pair of wires 33 for electrical connection between the semiconductor device 32 and the respective pair of leads 31b; and a hollow package 34 in which the entire die pad area 31a, part of the pair of leads 31b, the entire semiconductor device 32 laminated on the thermosetting sheet 3, and the entire pair of wires 33 are accommodated, and a gap formed between the package 34 and the semiconductor device 32 or the like is filled with a mold resin 35. That is, in the semiconductor apparatus 30 as shown in Fig. 2, the lead frame substrate 31 serves as a substrate having a semiconductor device mounting area, and the die pad 31a serves as the semiconductor device mounting area.

In the semiconductor apparatus 30, the pair of leads 31b each have one end side arranged above an upper surface of each of the both ends of the die pad 31a, and extend in a direction parallel to the upper surface of the die pad 31a (hereinafter referred to also as horizontal direction), and further extend downward in a direction vertical to the upper surface of the die pad 31a (hereinafter referred to simply as vertically downward). A portion of each of the pair of leads 31b that extends in the horizontal direction penetrates through the package 34. That is, in the semiconductor apparatus 30, the portion of the lead 31b extending in the horizontal direction is partially accommodated in the package 34, and a remainder of the portion thereof as well as the entire portion of the lead 31b extending vertically downward are exposed outside the package 34.

As shown in Fig. 2, the semiconductor apparatus 30 is mounted on a wiring board 40 including a pair of electrodes 41 arranged at an interval from each other on a surface of the wiring board 40 for use. More specifically, the semiconductor apparatus 30 is mounted on the wiring board 40 for use by connecting vertically downwardly extending portions of the pair of leads 31b to the respective pair of electrodes 41 by, for example, soldering.

In the semiconductor apparatus according to this embodiment, the thermosetting sheet is, as aforementioned, a thermosetting sheet including a thermosetting resin and a thermoplastic resin, in which a thickness change rate when a temperature is changed from 25 °C to 200 °C is 0% or more and 10% or less.

The joining ratio of the thermosetting sheet to the substrate can be obtained with the following steps:

(1) The opposite side to a side of a thermosetting sheet (or a laminated body formed to have a plurality of thermosetting sheets laminated on each other) on which a silicon chip (bare chip) is mounted is attached to a semiconductor device mounting area of a substrate, to thereby obtain a test piece for evaluating a joining ratio.

(2) Using an ultrasonic image apparatus (model: FineSAT FS200II manufactured by Hitachi Kenki Finetech Co.,

Ltd.; hereinafter referred to also as SAT), a SAT image of the test piece for evaluating the joining ratio is captured by the reflection method. In capturing the image, a gate is adjusted to conform to an echo of the bonded portion between the substrate and the thermosetting sheet, the echo being displayed on the waveform monitor of the ultrasonic image apparatus, with a pixel set to 1, a gain set to 25 dB, and a Z-axis height set to 11.34 mm.

(3) The obtained SAT image is subjected to automatic binarization processing, in which the image is binarized into a bonded portion between the substrate and the thermosetting sheet (hereinafter referred to also as bonded portion) and a non-bonded portion between the substrate and the thermosetting sheet (hereinafter referred to also as non-bonded portion), using ImageJ, image analysis software. The threshold is set to 82.

(4) The area of the bonded portion and the area of the non-bonded portion are obtained from the binarized image, the area value of the bonded portion is divided by the sum of the area of the bonded portion and the area of the non-bonded portion, and the obtained value is then multiplied by 100 to thereby obtain the joining ratio of the thermosetting sheet to the substrate.

In the binarized image, the bonded portion is shown in black while the non-bonded portion is shown in white.

The matters disclosed herein include the following:

(1) A thermosetting sheet including a thermosetting resin and a thermoplastic resin, in which a thickness change rate when a temperature is changed from 25 °C to 200 °C is 0% or more and 10% or less.

According to this configuration, the thermosetting sheet includes the thermosetting resin and the thermoplastic resin, in which a thickness change rate when a temperature is changed from 25 °C to 200 °C is 0% or more and 10% or less. Thus, it is possible to suppress the shrinkage of the thermosetting sheet when the thermosetting sheet is heat-cured and the bonding to the adherend is finalized. Since the shrinkage of the thermosetting sheet can be suppressed, it is possible to enable the thermosetting sheet to have a relatively small internal stress (i.e., cure shrinkage stress and heat shrinkage stress) generated in the thermosetting sheet during heat curing, to thereby relatively suppress the separation of the thermosetting sheet from the adherend. Further, the thermosetting sheet including the thermoplastic resin can have a relatively low elasticity even after being heat-cured. Thus, it is possible to secure the adhesiveness between the thermosetting sheet and the adherend even after being heat-cured.

(2) The thermosetting sheet of (1) above, including 60 mass parts or more and 500 mass parts or less of the thermoplastic resin based on 100 mass parts of the thermosetting resin.

According to this configuration, the separation of the thermosetting sheet from the adherend can be further suppressed.

(3) The thermosetting sheet of (1) or (2) above, further including conductive particles.

According to this configuration, the thermosetting sheet is allowed to exhibit the electric conductivity and the thermal conductivity via the conductive particles in addition to the capability of suppressing the separation of the thermosetting sheet from the adherend.

(4) The thermosetting sheet of (3) above, further including a volatile component.

According to this configuration, the thermosetting sheet further includes the volatile component so that the volume of the thermosetting sheet can be reduced by allowing the volatile component to be volatilized during heat-curing of the thermosetting sheet. The more the volume of the thermosetting sheet is reduced, the closer the conductive particles become to each other in the thermosetting sheet, allowing the conductive particles to easily form a thermal conduction path in the thermosetting sheet. This allows thermal conductivity after being cured to be relatively high. The volume shrinkage caused by volatilization of the volatile component (that is, the volume shrinkage due to volatilization) has less influence on separation of the thermosetting sheet from the adherend than the volume shrinkage caused by heat-curing of the thermosetting resin (that is, the volume shrinkage due to heat-curing). Thus, the thermosetting sheet is kept in the state where it's separation from the adherend is relatively suppressed even in the case where the volume shrinkage caused by volatilization occurs.

(5) The thermosetting sheet of (4) above, further including 10 mass parts or more and 300 mass parts or less of the volatile component based on 100 mass parts of the thermosetting resin.

According to this configuration, a thermal conduction path can be more easily formed in the thermosetting sheet by the conductive particles. This allows thermal conductivity after being cured to be much higher.

(6) A dicing die bonding film including: a dicing tape that includes a base layer and an adhesive layer laminated on the base layer; and a thermosetting sheet that is laminated on the adhesive layer of the dicing tape, in which the thermosetting sheet is the thermosetting sheet of any one of (1) to (5) above.

According to this configuration, the dicing die bonding film suppresses the separation of the thermosetting sheet from the adherend (i.e., the substrate having a semiconductor device mounting area).

The thermosetting sheet and the dicing die bonding film according to the present invention are not limited to the aforementioned embodiment. The thermosetting sheet and the dicing die bonding film according to the present

invention are not limited by the aforementioned operational advantages, either. Various modifications can be made for the thermosetting sheet and the dicing die bonding film according to the present invention without departing from the gist of the present invention.

## EXAMPLES

Hereinafter, the present invention will be more specifically described by way of examples. The following examples are provided for more specifically describing the present invention, and do not intend to limit the scope of the present invention.

[Example 1]

A mixture of materials having the respective mass ratios shown in the column "Example 1" of Table 1 below was stirred and mixed using a hybrid mixer (product name: HM-500 manufactured by KEYENCE CORPORATION) in the "stirring mode" to prepare a varnish. The stirring and mixing using the hybrid mixer was performed by three steps. Specifically, first, a primary mixture including a thermosetting resin and a thermoplastic resin was stirred and mixed for three minutes (i.e., primary stirring), then a secondary mixture obtained by adding conductive particles and a volatile agent to the primary mixture was stirred and mixed for 6 minutes (i.e., secondary stirring), and further a tertiary mixture obtained by adding a catalyst and a solvent to the secondary mixture was stirred and mixed for 3 minutes (i.e., tertiary stirring). The varnish was applied to one side of a release treatment film (product name: MRA38, with a thickness of 38 μm, manufactured by Mitsubishi Chemical Corporation), followed by being allowed to dry at 100 °C for 2 minutes to obtain a thermosetting sheet having a thickness of 30 μm. The materials shown in Table 1 below are as follows:

- Phenol resin
  MEHC-7851S (biphenyl type phenol resin, phenol equivalent of 209 g/eq), manufactured by MEIWA PLASTIC INDUSTRIES, LTD.
- Solid epoxy resin
  KI-3000-4 (cresol novolak type multifunctional epoxy resin, epoxy equivalent of 200 g/eq), manufactured by Nippon Steel & Sumikin Chemical Co., Ltd.
- Liquid epoxy resin
  YL980 (bisphenol A type epoxy resin, epoxy equivalent of 180 to 190 g/eq), manufactured by Mitsubishi Chemical Corporation
- Silver (Ag)-coated copper (Cu) particles
  Product name AOP-TCY-2 (EN) (spherical copper particles coated with 20 mass % of silver particles; the particles have a spherical shape) manufactured by DOWA Electronics Materials Co., Ltd.
- Silver (Ag) particles
  AG-2-8F (silver particles subjected to surface treatment with an aliphatic acid-based coating agent; the particles have a spherical shape) manufactured by DOWA Electronics Materials Co., Ltd.
- Volatile agent (isobornyl cyclohexanol (MTPH))
  MTPH manufactured by Nippon Terpene Chemicals, Inc.
- Acrylic resin solution
  TEISANRESIN SG-70L (including MEK and toluene as solvents, solid content of 12.5%, glass transition temperature of -13 °C, mass-average molecular weight of 900,000, acid value of 5 mg/KOH, carboxyl group-containing acrylic copolymer), manufactured by Nagase ChemteX Corporation
- Coupling agent
  KBE-846 (bis(triethoxysilylpropyl)tetrasulfide), manufactured by Shin-Etsu Chemical Co., Ltd.
- Catalyst
  TPP-MK (tetraphenylphosphonium tetra-p-tolylborate), manufactured by HOKKO CHEMICAL INDUSTRY CO., LTD.
- Solvent
  Methyl ethyl ketone (MEK)

Table 2 below shows the mass ratio (mass parts) of the thermoplastic resin (acrylic resin, hereinafter also referred to as TMR) based on 100 mass parts of the thermosetting resin (epoxy resin (solid and liquid) and phenol resin, hereinafter also referred to as TSR), the mass ratio (mass parts) of the volatile agent (isobornyl cyclohexanol) based on 100 mass parts of the thermosetting resin, and the mass ratio (mass parts) of the conductive particles based on 100 mass parts of the thermosetting resin. Further, Table 3 below shows the mass ratios respectively of the silver-coated copper particles and the silver particles based on 100 mass parts of the conductive particles (silver-coated copper particles and silver particles).

[Example 2]

A thermosetting sheet according to Example 2 was obtained in the same manner as in Example 1, except that a mixture of materials having the respective mass ratios shown in the column Example 2 of Table 1 below was obtained.

[Example 3]

A thermosetting sheet according to Example 3 was obtained in the same manner as in Example 1, except that a mixture of materials having the respective mass ratios shown in the column Example 3 of Table 1 below was obtained.

[Example 4]

A thermosetting sheet according to Example 4 was obtained in the same manner as in Example 1, except that a mixture of materials having the respective mass ratios shown in the column Example 4 of Table 1 below was obtained.

[Example 5]

A thermosetting sheet according to Example 5 was obtained in the same manner as in Example 1, except that a mixture of materials having the respective mass ratios shown in the column Example 5 of Table 1 below was obtained.

[Comparative Example 1]

A thermosetting sheet according to Comparative Example 1 was obtained in the same manner as in Example 1, except that a mixture of materials having the respective mass ratios shown in the column Comparative Example 1 of Table 1 below was obtained.

[Comparative Example 2]

A thermosetting sheet according to Comparative Example 2 was obtained in the same manner as in Example 1, except that a mixture of materials having the respective mass ratios shown in the column Comparative Example 2 of Table 1 below was obtained.

Table 1

| | Unit | Ex. 1 | Ex. 2 | Ex. 3 | Ex. 4 |
|---|---|---|---|---|---|
| Phenol resin | Mass parts | 0.84 | 0.50 | 0.50 | 0.74 |
| Solid epoxy resin | Mass parts | 0.55 | 0.33 | 0.40 | 0.60 |
| Liquid epoxy resin | Mass parts | 0.23 | 0.14 | 0.07 | 0.11 |
| Ag-coated Cu particles | Mass parts | 13.1 | 13.2 | 16.1 | 14.4 |
| Ag particles | Mass parts | 30.7 | 30.9 | 37.7 | 33.6 |
| Isobornyl cyclohexanol (MTPH) | Mass parts | 0.81 | 0.81 | 0.36 | 0.72 |
| Acrylic resin solution | Mass parts | 13.0 | 18.1 | 18.2 | 11.6 |
| Coupling agent | Mass parts | 0.12 | 0.12 | 0.11 | 0.11 |
| Catalyst | Mass parts | 0.010 | 0.010 | 0.010 | 0.010 |
| Methyl ethyl ketone (MEK, solvent) | Mass parts | 8.0 | 3.5 | 5.9 | 14.2 |

(continued)

| | Unit | Ex. 1 | Ex. 2 | Ex. 3 | Ex. 4 |
|---|---|---|---|---|---|
| | Unit | Ex. 5 | C. Ex. 1 | C. Ex. 2 | |
| Phenol resin | Mass parts | 0.84 | 1.17 | 1.06 | |
| Solid epoxy resin | Mass parts | 0.39 | 0.77 | 0.48 | |
| Liquid epoxy resin | Mass parts | 0.39 | 0.33 | 0.48 | |
| Ag-coated Cu particles | Mass parts | 11.5 | 13.1 | 16.2 | |
| Ag particles | Mass parts | 26.8 | 30.5 | 37.9 | |
| Isobornyl cyclohexanol (MTPH) | Mass parts | 0.36 | 0.81 | 0.72 | |
| Acrylic resin solution | Mass parts | 13.0 | 7.77 | 6.94 | |
| Coupling agent | Mass parts | 0.11 | 0.12 | 0.11 | |
| Catalyst | Mass parts | 0.010 | 0.010 | 0.010 | |
| Methyl ethyl ketone (MEK, solvent) | Mass parts | 2.6 | 12.3 | 21.2 | |

Table 2

| | | Ex. 1 | Ex. 2 | Ex. 3 | Ex. 4 |
|---|---|---|---|---|---|
| Thermosetting resin | Solid epoxy resin | 34.0 mass parts | 34.0 mass parts | 41.2 mass parts | 41.4 mass parts |
| | Liquid epoxy resin | 14.2 mass parts | 14.4 mass parts | 7.2 mass parts | 7.6 mass parts |
| | Phenol resin | 51.9 mass parts | 51.5 mass parts | 51.5 mass parts | 51.0 mass parts |
| | Total | 100 mass parts | 100 mass parts | 100 mass parts | 100 mass parts |
| Thermoplastic resin (acrylic resin) | | 99.9 mass parts | 233.6 mass parts | 234.5 mass parts | 99.7 mass parts |
| Volatile agent (MTPH) | | 50 mass parts | 83.5 mass parts | 37.1 mass parts | 49.7 mass parts |
| Conductive particles | | 2703 mass parts | 4546 mass parts | 5546 mass parts | 3310 mass parts |
| | | Ex. 5 | C. Ex. 1 | C. Ex. 2 | |
| Thermosetting resin | Solid epoxy resin | 24.1 mass parts | 33.9 mass parts | 23.8 mass parts | |
| | Liquid epoxy resin | 24.1 mass parts | 14.5 mass parts | 23.8 mass parts | |
| | Phenol resin | 51.9 mass parts | 51.5 mass parts | 52.5 mass parts | |
| | Total | 100 mass parts | 100 mass parts | 100 mass parts | |
| Thermoplastic resin (acrylic resin) | | 100.3 mass parts | 42.8 mass parts | 42.9 mass parts | |
| Volatile agent (MTPH) | | 22.2 mass parts | 35.7 mass parts | 35.6 mass parts | |
| Conductive particles | | 2364 mass parts | 1921 mass parts | 2678 mass parts | |

<Packing ratio of conductive particles>

The packing ratio $P_1$ of the conductive particles was obtained for the thermosetting sheet before being cured according to each of Examples and Comparative Examples with the following steps:

(1) The thermosetting sheet before being cured is mechanically polished to expose its cross section, and the exposed cross section is subjected to ion polishing using an ion polisher (for example, product name: Cross Section Polisher SM-09010 manufactured by JEOL, Ltd.).
(2) An SEM image (an image obtained by a scanning electron microscope) of a given cross-sectional area of the exposed cross section that had been ion-polished is captured using a field emission scanning electron microscope SU8020 (manufactured by Hitachi High-Tech Corporation) at an accelerating voltage of 5 kV and at a magnification of 5000 times to obtain a reflected electron image as an image data.
(3) The obtained image data is subjected to automatic binarization processing, in which the data was binarized into a metal portion and a resin portion using ImageJ, image analysis software.
(4) The total area of the metal portion and the entire (metal portion + resin portion) area are obtained from the binarized image, and the total area of the metal portion is divided by the entire area to obtain the packing ratio P of the conductive particles in the cured thermosetting sheet.

The packing ratio $P_1$ of the particles was obtained by arithmetically averaging the packing ratios obtained for five cross-sectional areas in the exposed cross section that had been ion-polished. The packing ratio $P_1$ of the particles obtained for the thermosetting sheet before being cured according to each of Examples and Comparative Examples is shown in Table 3 below. The packing ratio $P_2$ of the conductive particles was obtained for the thermosetting sheet after being cured according to each of Examples and Comparative Examples in the same manner as described above. The packing ratio $P_2$ of the particles obtained for the thermosetting sheet after being cured according to each of Examples and Comparative Examples is shown in Table 3 below.

<Thermal conductivity of thermosetting sheet>

The thermosetting sheet according to each of Examples and Comparative Examples was heat-cured using a pressure cooker apparatus under 0.5 MPa pressure at 200 °C for an hour. The thermal conductivity for the heat-cured thermosetting sheet according to each of Examples and Comparative Examples was calculated using the equation below:

$$\text{Thermal conductivity (W/m}\cdot\text{K)} = \text{Thermal diffusivity (m}^2\text{/s)} \times \text{Specific heat (J/g}\cdot\,^\circ\text{C)} \times \text{Specific weight (g/cm}^3\text{)}$$

The thermal diffusivity $\alpha$ ($m^2/s$) was measured by the TWA method (temperature wave analysis, measuring instrument: ai-Phase Mobile manufactured by ai-Phase Co., Ltd.). The specific heat $C_p$ (J/g· °C) was measured by the DSC method. In the specific heat measurement, DSC6220 manufactured by SII NanoTechnology Inc. was used at a temperature rising rate of 10 °C/min and in a temperature range of 20 to 300 °C to obtain the data, based on which the specific heat was calculated according to the method stipulated in the JIS handbook (Testing Methods for Specific Heat Capacity of Plastics: K-7123). Specific weight was measured by the Archimedes method. The calculated thermal diffusivity for the cured thermosetting sheet according to each of Examples and Comparative Examples is shown in Table 3 below.

<Joining ratio>

The joining ratio of the thermosetting sheet according to each of Examples to the substrate was measured. In measuring the joining ratio, the thermosetting sheet according to each of Examples was cut into a 5 cm square, and ten pieces of the 5 cm square cut sheet were laminated on each other and pressed under vacuum (under a pressure of 3.3 kPa) to obtain a sheet laminated body having a thickness of 300 μm. Then, a bare chip diced into a 5 cm square was attached to one side of the sheet laminated body to produce a sheet laminated body provided with a bare chip. The joining ratio to the substrate was measured with the following steps:

(1) The opposite side to the one side of the sheet laminated body on which the bare chip is mounted is attached to a die pad of a lead frame substrate (Cu lead frame substrate) to obtain a test piece for evaluating a joining ratio.
(2) Using an ultrasonic image apparatus (model: FineSAT FS200II manufactured by Hitachi Kenki Finetech Co., Ltd.; hereinafter referred to also as SAT), a SAT image of the test piece for evaluating the joining ratio is captured

by the reflection method. In capturing the image, a gate is adjusted to conform to an echo of the bonded portion between the lead frame substrate and the sheet laminated body, the echo image displayed on the waveform monitor of the ultrasonic image apparatus, with a pixel set to 1, a gain set to 25 dB, and a Z-axis height set to 11.34 mm.
(3) The obtained SAT image is subjected to automatic binarization processing, in which the image is binarized into a bonded portion between the lead frame substrate and the sheet laminated body (hereinafter referred to also as bonded portion) and a non-bonded portion between the lead frame substrate and the sheet laminated body (hereinafter referred to also as non-bonded portion), using ImageJ, image analysis software. The threshold is set to 82.
(4) The area of the bonded portion and the area of the non-bonded portion are obtained from the binarized image, the area value of the bonded portion is divided by the sum of the area of the bonded portion and the area of the non-bonded portion, and the obtained value is then multiplied by 100 to thereby obtain the joining ratio of the sheet laminated body to the lead frame substrate (i.e., the joining ratio of the thermosetting sheet bonded to the lead frame substrate to the lead frame substrate).

In the binarized image, the bonded portion is shown in black while the non-bonded portion is shown in white.
The measured joining ratio of the thermosetting sheet according to each of Examples to the substrate (lead frame substrate) is shown in Table 3 below.

< Thickness change rate Rc >

The thickness change rate Rc when a temperature is changed from 25 °C to 200 °C was obtained for the thermosetting sheet according to each of Examples and Comparative Examples with the following step. Specifically, the thickness change ratio Rc was obtained by measuring the thickness T1 of the thermosetting sheet at 25 °C and the thickness T2 of the thermosetting sheet immediately after being raised to 200 °C when the temperature is changed from 25 °C to 200 °C in a thermomechanical analysis (TMA), followed by calculating the equation below using the measured values T1 and T2.

$$Rc = (T2\text{-}T1) / T1 \times 100$$

The thermomechanical analysis was performed in the following conditions.

CONDITIONS OF THERMOMECHANICAL ANALYSIS

- Thermomechanical analysis apparatus: model Q400 manufactured by TA Instruments Japan Inc.
- Probe: macro expansion probe
- Measurement mode: compression and expansion
- Temperature raising conditions: the temperature is raised from 25 °C to 200 °C in 60 minutes, held at 200 °C for 1 hour, and then lowered to 25 °C in 30 min.
- Measurement environment: Nitrogen ($N_2$)
- Load: 0.012 N (constant load)
- Test piece: A first thermosetting sheet laminate in which a plurality of thermosetting sheets are laminated is pressed under the conditions at a temperature of 70 °C and a pressure of 6 kN for 60 seconds to obtain a second thermosetting sheet laminate having a thickness of 3mm, followed by punching the second thermosetting sheet laminate by a punch having a diameter of 4mm, to obtain a test piece having a thickness of 3 mm and a diameter of 4 mm.

The measurement by the thermomechanical analysis apparatus was performed by placing the test piece having each of both sides with an aluminum plate disposed thereon (having a circular shape in a plan view, a thickness of 0.1 mm, and a plane dimension with a dimeter of 5 mm) on a stage of the thermomechanical analysis apparatus to allow the aluminum plate on one side to contact the stage, followed by applying a load by the probe from the aluminum plate on the other side (i.e., the aluminum plate on the upper side). Rc was obtained by arithmetically averaging the values obtained for two test pieces.
The measured thickness change rate Rc of the thermosetting sheet according to each of Examples and Comparative Examples is shown in Table 3 below. The graph showing the transition of the thickness change rate Rc obtained in performing thermomechanical analysis for the thermosetting sheet according to each of Examples and Comparative Examples is shown in Figs. 3A and 3B.

Table 3

| | | Unit | Ex.1 | Ex. 2 | Ex. 3 | Ex. 4 |
|---|---|---|---|---|---|---|
| Conductive particles | Ag particle type | - | AG-2-8F | AG-2-8F | AG-2-8F | AG-2-9F |
| | Mass parts of Ag particles based on 100 mass parts of conductive particles | Mass parts | 70 | 70 | 70 | 70 |
| | Ag-coated Cu particle type | - | AOP-TCY-2 (EN) | AOP-TCY-2 (EN) | AOP-TCY-2 (EN) | AOP-TCY-2 (EN) |
| | Mass parts of Ag-coated Cu particles based on 100 mass parts of conductive particles | Mass parts | 30 | 30 | 30 | 30 |
| Mass parts of TMR based on 100 mass parts of TSR | | Mass parts | 99.9 | 233.6 | 234.5 | 99.7 |
| Mass parts of MTPH based on 100 mass parts of TSR | | Mass parts | 50 | 83.5 | 37.1 | 49.7 |
| Packing ratio P1 in thermosetting sheet before being cured | | vol% | 55 | 55 | 63 | 60 |
| Packing ratio P2 in thermosetting sheet after being cured | | vol% | 62.5 | 60.9 | 65.1 | 64.9 |
| Thermal conductivity of thermosetting sheet after being cured | | W/m·K | 11.1 | 8.7 | 8.5 | 13.0 |
| joining ratio before heat-curing JR1 | | % | 98.4 | 95.4 | 86.5 | 99.7 |
| joining ratio after heat-curing JR2 | | % | 96.9 | 94.2 | 85.1 | 92.0 |
| JR2/JR1 × 100 | | % | 98.5 | 98.8 | 98.4 | 92.3 |
| Thickness change rate Rc Immediately after being raised to 200 ° C | | % | 5.0 | 7.1 | 5.8 | 2.8 |

(continued)

| | | Unit | Ex.1 | Ex. 2 | Ex. 3 | Ex. 4 |
|---|---|---|---|---|---|---|
| | | Unit | Ex. 5 | C. Ex. 1 | C. Ex. 2 | |
| Conductive particles | Ag particle type | - | AG-2-8F | AG-28F | AG-2-8F | |
| | Mass parts of Ag particles based on 100 mass parts of conductive particles | Mass parts | 70 | 70 | 70 | |
| | Ag-coated Cu particle type | - | AOP-TCY-2 (EN) | AOP-TCY-2 (EN) | AOP-TCY-2 (EN) | |
| | Mass parts of Ag-coated Cu particles based on 100 mass parts of conductive particles | Mass parts | 30 | 30 | 30 | |
| Mass parts of TMR based on 100 mass parts of TSR | | Mass parts | 100.3 | 42.8 | 42.9 | |
| Mass parts of MTPH based on 100 mass parts of TSR | | Mass parts | 22.2 | 35.7 | 35.6 | |
| Packing ratio P1 in thermosetting sheet before being cured | | vol% | 55 | 55 | 63 | |
| Packing ratio P2 in thermosetting sheet after being cured | | vol% | 57.5 | 62.7 | 67.2 | |
| Thermal conductivity of thermosetting sheet after being cured | | W/m·K | 4.2 | 14.5 | 19.6 | |
| joining ratio before heat-curing JR1 | | % | 98.8 | 98.7 | 92.6 | |
| joining ratio after heat-curing JR2 | | % | 98.8 | 76.8 | 20.6 | |
| JR2/JR1 × 100 | | % | 100.0 | 77.83 | 22.2 | |
| Thickness change rate Rc immediately after being raised to 200° C | | % | 4.5 | -4.4 | -1.8 | |

Table 3 shows that the thermosetting sheet according to each of Examples has a joining ratio before heat-curing JR1 having a high value of 85% or more, a joining ratio after heat-curing JR2 having a high value of 85% or more, and a ratio of the joining ratio after heat-curing JR2 to the joining ratio before heat-curing JR1 having a high value of 90% or more. In contrast, Table 3 shows that the thermosetting sheet according to Comparative Example 1 has a joining ratio after heat-curing JR2 having a low value of 76.8%, while having a joining ratio before heat-curing JR1 having a high value of 98.70%, and a ratio of the joining ratio after heat-curing JR2 to the joining ratio before heat-curing JR1 has being largely reduced to 77.8%. Also, Table 3 shows that the thermosetting sheet according to Comparative Example 2 has a joining ratio after heat-curing JR2 having a significantly low value of 20.6%, while having a joining ratio before heat-curing JR1 showing a high value of 92.6%, and a ratio of the joining ratio after heat-curing JR2 to the joining ratio before heat-curing JR1 has a significantly low value of 22.2%. Further, Figs. 4A to 4D show examples (Example 5 and Comparative Example 2) of the SAT image (i.e., SAT image captured using an ultrasonic image apparatus) of the thermosetting sheet before and after being cured, in which no separation was observed on the end edge side after being cured for the thermosetting sheet according to Example 5 (Figs. 4A and 4B). In contrast, in the thermosetting sheet according to Comparative Example 2 (Figs. 4C and 4D), large separation from the end edge side was observed after being cured, and only the portion at the center and its peripheral area was kept joined. As described above, the SAT images also show that there is a significant difference between the thermosetting sheet according to Examples and the thermosetting sheet according to Comparative Examples in terms of the separability from the adherend. Further, all of the thickness change rates Rc in Examples fall within the range of 0% or more and 10% or less, namely, that of the thermosetting sheet according to Example 1 is 5.0%, that of the thermosetting sheet according to Example 2 is 7.1%, that of the thermosetting sheet according to Example 3 is 5.8%, that of the thermosetting sheet according to Example 4 is 2.8%, and that of the thermosetting sheet according to Example 5 is 4.5%. In contrast, the thickness change rates

Rc of the thermosetting sheets according to Comparative Examples 1 and 2 are respectively -4.4% and -1.8%, which fall out of the range of 0% or more and 10% or less. These results show that the separation of the thermosetting sheet after being heat-cured from the adherend is relatively suppressed since the thermosetting sheet includes the thermosetting resin and the thermoplastic resin and is further configured to have a thickness change rate Rc within the range of 0% or more and 10% or less.

Table 3 shows that the thermosetting sheet according to each of Examples 1 to 5 can obtain a sufficient thermal conductivity exceeding 4 W/m·K since the packing ratio $P_2$ of the conductive particles in the thermosetting sheet after being cured is 50 volume % or more.

Tables 3A and 3B show that the thickness change rate Rc in the thermosetting sheet according to each of Comparative Examples 1 and 2 continues to decrease, while mostly having a negative value as the heating temperature is raised. The thickness change rate Rc in the thermosetting sheet according to each of Comparative Examples 1 and 2 shows a tendency to continue to further decrease during the period in which the temperature is kept at 200 °C for allowing the heat-curing reaction to proceed further. During this period in which the temperature is kept, the minimum thickness change rate Rc in the thermosetting sheet according to Comparative Example 1 is -6.7% and the minimum thickness change rate Rc in the thermosetting sheet according to Comparative Example 2 is -5.6%. The thickness change rate Rc in the thermosetting sheet according to each of Comparative Examples 1 and 2 shows a more negative value (-7.9% at minimum in the thermosetting sheet according to Comparative Example 1, and -7.3% at minimum in the thermosetting sheet according to Comparative Example 2) in association with the volume shrinkage of the resin components by cooling after the period during which the temperature is kept at of 200 °C.

In contrast, Figs. 3A and 3B show that the thickness change rate Rc in the thermosetting sheet according to each of Examples 1 to 5 has a tendency to continue to increase while mostly having positive values as the heating temperature is raised (specifically, the thickness change rate Rc in the thermosetting sheet according to Example 1 has a positive value when the temperature is 50 °C or more, the thickness change rate Rc in the thermosetting sheet according to each of Examples 2 and 4 has a positive value immediately after it is heated, and the thickness change rate Rc in the thermosetting sheet according to each of Examples 3 and 5 has a positive value when the temperature is 30 °C or more) and reaches the maximum value (3.9% at maximum in the thermosetting sheet according to Example 1, 8% at maximum in the thermosetting sheet according to Example 2, 5.8% at maximum in the thermosetting sheet according to Example 3, 3% at maximum in the thermosetting sheet according to Example 4, 4.5% at maximum in the thermosetting sheet according to Example 5) within a temperature range of not less than 100 °C but not more than 200 °C. The thickness change rate Rc in the thermosetting sheet according to each of Examples 1 to 3 continues to have a positive value although it has a tendency to decrease during the period in which the temperature is kept at 200 °C for allowing the heat-curing reaction to proceed further. The thickness change rate Rc in the thermosetting sheet according to each of Examples 1 and 2 still continues to have a positive value although it becomes smaller because of the volume shrinkage of the resin components by cooling after the period during which the temperature is kept at 200 °C. In contrast, the thickness change rate Rc in the thermosetting sheet according to Example 3 has a higher value than that of the thickness change rate Rc of the thermosetting sheet of each of Comparative Examples 1 and 2 while having a negative value (-2.3% at minimum) because of cooling after the period during which the temperature is kept at 200 °C. The thickness change rate Rc in the thermosetting sheet according to each of Examples 4 and 5 has a higher value than that of the thickness change rate Rc of the thermosetting sheet according to each of Comparative Examples 1 and 2, although it has a tendency to decrease to have a negative value during the temperature is kept at 200 °C for allowing the heat-curing reaction to proceed further, and has a smaller negative value by cooling after the period during which the temperature is kept at 200 °C (-5.3% at minimum in the thermosetting sheet according to Example 4, and -4.9% at minimum in the thermosetting sheet according to Example 5).

In consideration of the above results, it can be understood that the thermosetting sheet according to this embodiment preferably has a thickness change rate Rc of more than 0% (has a positive value) within the temperature range of not less than 50 °C but not more than 200 °C when the temperature is changed from 25 °C to 200 °C. It can also be understood that it is preferable that the thermosetting sheet according to this embodiment preferably have the maximum value of the thickness change rate Rc within the temperature range of not less than 100 °C but not more than 200 °C when the temperature is changed from 25 °C to 200 °C, and the maximum value thereof be 3% or more. It is considered that, since the solid epoxy resin generally starts to soften at the temperature between 80 °C and 100 °C, the thickness change rate Rc of the thermosetting sheet as a positive value at the temperature between 80 °C and 100 °C, and therefore the thermosetting sheet allows the heat-curing reaction to proceed in a state where its adhesiveness to the adherend is improved. Thus, the adhesiveness of the thermosetting sheet to the adherend is further improved, that is, the separation of the thermosetting sheet after it is heat-cured from the adherend is further suppressed.

REFERENCE SIGNS LIST

1: Base layer
2. Adhesive layer
3: Thermosetting sheet
10: Dicing tape
20: Dicing die bonding film
30: Semiconductor apparatus
31: Lead frame substrate
32: Semiconductor device
33: Wire
34: Package
35: Mold resin
40: Wiring board
41: Electrode
31a: Die pad
31b: Lead

**Claims**

**1.** A thermosetting sheet comprising a thermosetting resin and a thermoplastic resin, wherein
a thickness change rate when a temperature is changed from 25 °C to 200 °C is 0% or more and 10% or less.

**2.** The thermosetting sheet according to claim 1, comprising
60 mass parts or more and 500 mass parts or less of the thermoplastic resin based on 100 mass parts of the thermosetting resin.

**3.** The thermosetting sheet according to claim 1 or 2, further comprising conductive particles.

**4.** The thermosetting sheet according to claim 3, further comprising a volatile component.

**5.** The thermosetting sheet according to claim 4, comprising
10 mass parts or more and 300 mass parts or less of the volatile component based on 100 mass parts of the thermosetting resin.

**6.** A dicing die bonding film, comprising:

a dicing tape that comprises a base layer and an adhesive layer laminated on the base layer; and
a thermosetting sheet that is laminated on the adhesive layer of the dicing tape, wherein
the thermosetting sheet is the thermosetting sheet according to any one of claims 1 to 5.

Fig.1

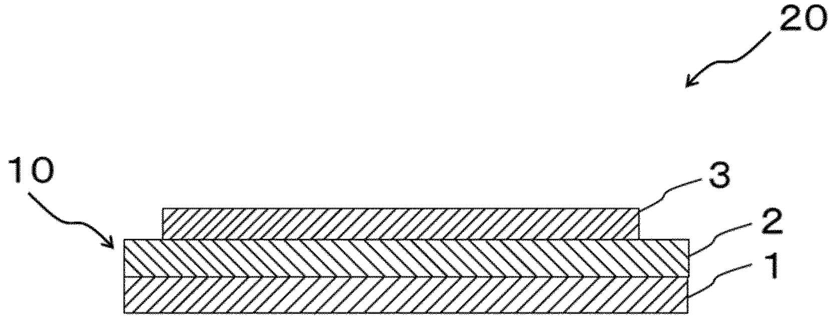


Fig.2

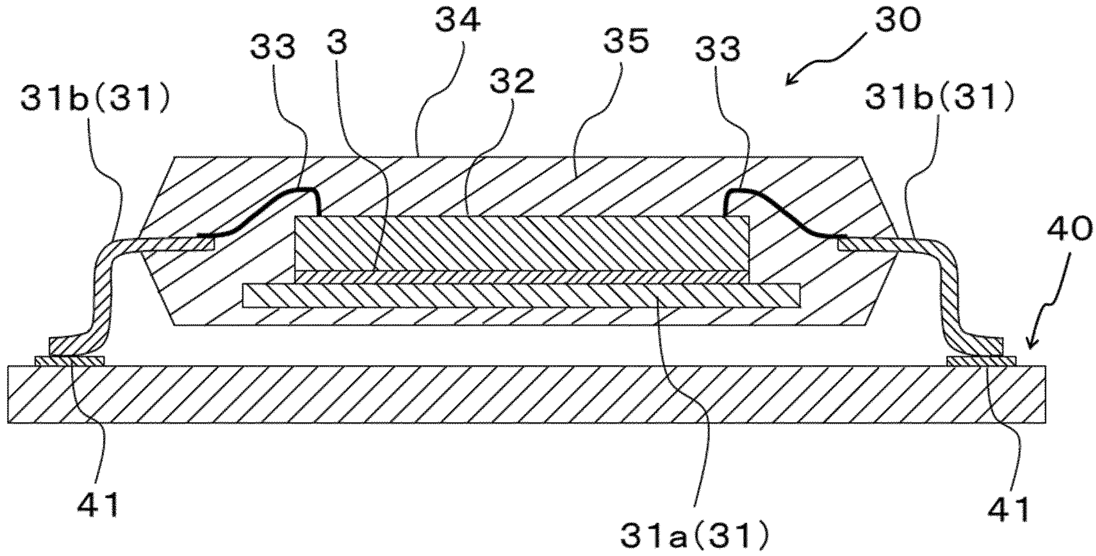

Fig.3A

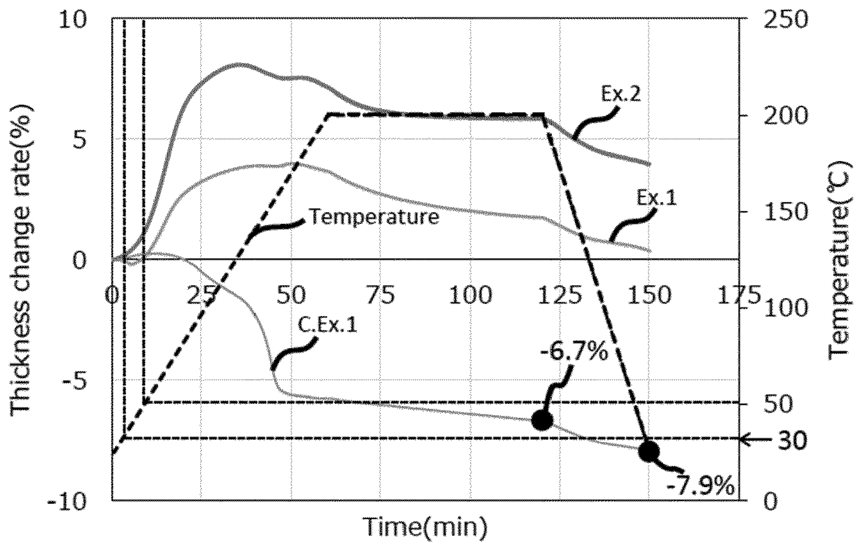
Thickness change rate(%)
Temperature(℃)
Time(min)
Ex.2
Ex.1
Temperature
C.Ex.1
-6.7%
-7.9%
30
10
5
0
-5
-10
0
25
50
75
100
125
150
175
250
200
150
100
50
0

Fig.3B

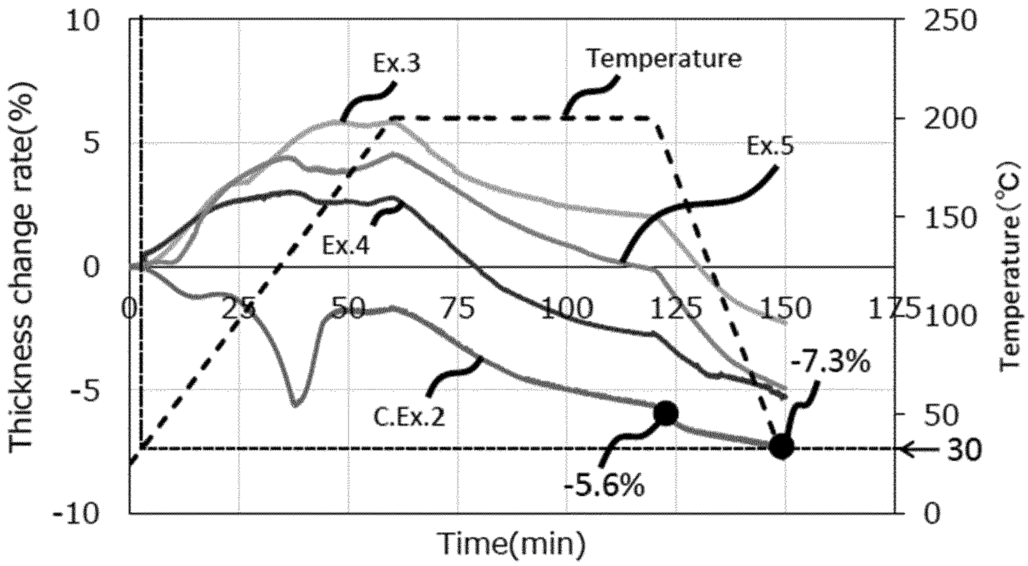
Thickness change rate(%)
Temperature(℃)
Time(min)
Ex.3
Temperature
Ex.5
Ex.4
C.Ex.2
-7.3%
-5.6%
30
10
5
0
-5
-10
0
25
50
75
100
125
150
175
250
200
150
100
50
0

Fig.4A

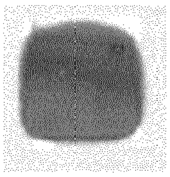

Fig.4C

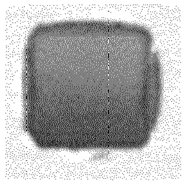

Fig.4B

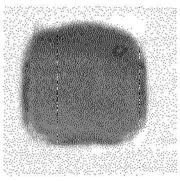

Fig.4D

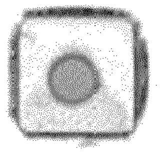

Europäisches Patentamt
European Patent Office
Office européen des brevets

# EUROPEAN SEARCH REPORT

Application Number
EP 22 16 5596

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| E | EP 3 988 626 A1 (NITTO DENKO CORP [JP]) 27 April 2022 (2022-04-27)<br>* examples 1,2,3 *<br>* the whole document *<br>----- | 1-4,6 | INV.<br>C09J7/10<br>B32B7/12<br>C08K3/08<br>H01L21/683 |
| X,P | EP 3 929 258 A1 (NITTO DENKO CORP [JP]) 29 December 2021 (2021-12-29)<br>* example 5 *<br>* the whole document *<br>----- | 1-4,6 | |
| X,P | EP 3 819 348 A1 (NITTO DENKO CORP [JP]) 12 May 2021 (2021-05-12)<br>* examples 1-4 *<br>* the whole document *<br>----- | 1,3-6 | |
| X<br>A | US 2011/120614 A1 (SUGO YUKI [JP] ET AL) 26 May 2011 (2011-05-26)<br>* examples 3-1,4-1 *<br>* paragraphs [0011] - [0026] *<br>----- | 1,2,6<br>3-5 | |
| A | US 2013/095639 A1 (TAKAMOTO NAOHIDE [JP] ET AL) 18 April 2013 (2013-04-18)<br>* the whole document *<br>----- | 1-6 | TECHNICAL FIELDS SEARCHED (IPC)<br>C09J<br>C08K<br>B32B<br>H01L |

The present search report has been drawn up for all claims

1

| Place of search | Date of completion of the search | Examiner |
|---|---|---|
| Munich | 3 August 2022 | Alevizopoulou, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# ANNEX TO THE EUROPEAN SEARCH REPORT ON EUROPEAN PATENT APPLICATION NO.

EP 22 16 5596

This annex lists the patent family members relating to the patent documents cited in the above-mentioned European search report. The members are as contained in the European Patent Office EDP file on
The European Patent Office is in no way liable for these particulars which are merely given for the purpose of information.

03-08-2022

| Patent document cited in search report | Publication date | Patent family member(s) | Publication date |
|---|---|---|---|
| EP 3988626 A1 | 27-04-2022 | CN 114479343 A | 13-05-2022 |
| | | EP 3988626 A1 | 27-04-2022 |
| | | JP 2022069969 A | 12-05-2022 |
| | | US 2022130790 A1 | 28-04-2022 |
| EP 3929258 A1 | 29-12-2021 | CN 113831865 A | 24-12-2021 |
| | | EP 3929258 A1 | 29-12-2021 |
| | | TW 202208585 A | 01-03-2022 |
| | | US 2021403784 A1 | 30-12-2021 |
| EP 3819348 A1 | 12-05-2021 | CN 112778943 A | 11-05-2021 |
| | | EP 3819348 A1 | 12-05-2021 |
| | | JP 2021077766 A | 20-05-2021 |
| | | TW 202124625 A | 01-07-2021 |
| | | US 2021139746 A1 | 13-05-2021 |
| US 2011120614 A1 | 26-05-2011 | CN 102153956 A | 17-08-2011 |
| | | JP 5632695 B2 | 26-11-2014 |
| | | JP 2011135042 A | 07-07-2011 |
| | | KR 20110058722 A | 01-06-2011 |
| | | TW 201120178 A | 16-06-2011 |
| | | TW 201402757 A | 16-01-2014 |
| | | US 2011120614 A1 | 26-05-2011 |
| US 2013095639 A1 | 18-04-2013 | CN 102947930 A | 27-02-2013 |
| | | KR 20130056863 A | 30-05-2013 |
| | | TW 201203425 A | 16-01-2012 |
| | | US 2013095639 A1 | 18-04-2013 |
| | | WO 2011132648 A1 | 27-10-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2019021813 A
- JP S60196956 A